(19) Europäisches Patentamt
European Patent Office
Office européen des brevets

(11) EP 0 994 118 A2

(12) EUROPEAN PATENT APPLICATION

(43) Date of publication:
19.04.2000 Bulletin 2000/16

(21) Application number: 99307253.7

(22) Date of filing: 14.09.1999

(51) Int Cl.[7]: **C07F 19/00**, C07F 3/00, C07F 7/00, C07F 5/00, C07F 15/00, C23C 16/00

(84) Designated Contracting States:
**AT BE CH CY DE DK ES FI FR GB GR IE IT LI LU MC NL PT SE**
Designated Extension States:
**AL LT LV MK RO SI**

(30) Priority: **28.09.1998 KR 9840371**

(71) Applicant: **ROHM AND HAAS COMPANY**
**Philadelphia, Pennsylvania 19106-2399 (US)**

(72) Inventor: **Shin, Hyun-Koock, Salgugol Hyundai**
**Suwon, Kyungki-Do 442-470 (KR)**

(74) Representative: **Buckley, Guy Julian et al**
**ROHM AND HAAS (UK) LTD.**
**European Operations Patent Department**
**Lennig House**
**2 Mason's Avenue**
**Croydon CR9 3NB (GB)**

(54) **Complex for the high dielectric film deposition and the method of deposition**

(57) Vapor deposition precursor compositions comprising certain organometallic compounds are disclosed. Also disclosed are methods of preparing the compositions as well as methods of vapor depositing a metal film using the organometallic compounds.

FIG. 1

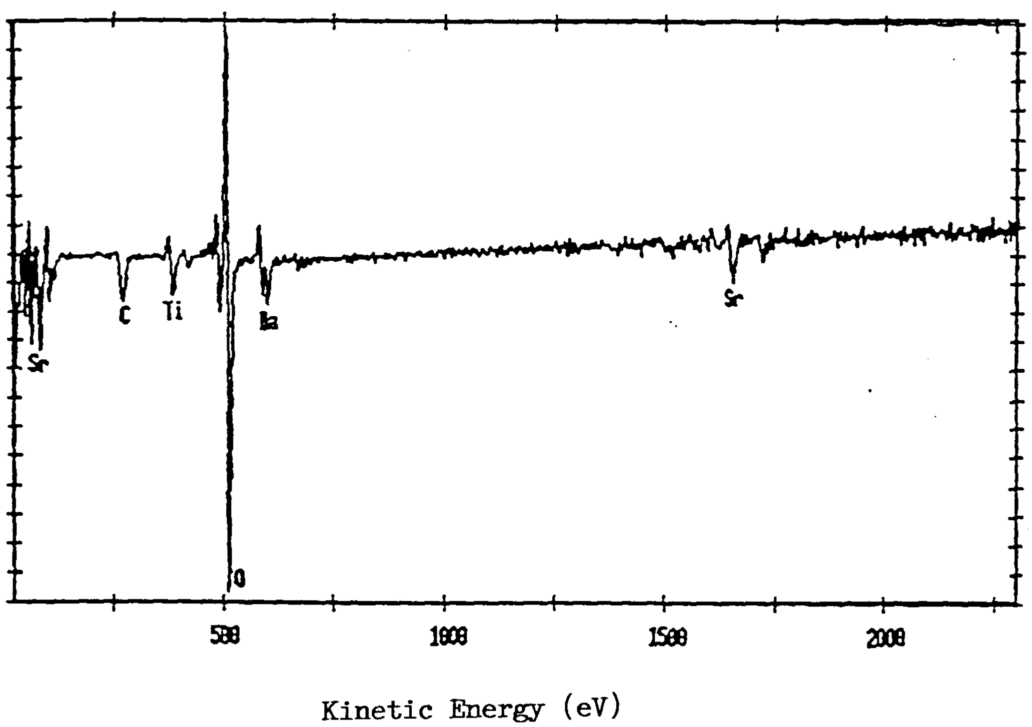


EP 0 994 118 A2

Printed by Jouve, 75001 PARIS (FR)

## Description

Background of the Invention

This invention relates generally to the field of vapor deposition of thin films. In particular, this field relates generally to the field of vapor deposition of thin films of dielectrics for use in semiconductors.

The area of a cell of DRAM (dynamic random access memory) has been decreasing with the trend toward a high degree of integration and miniaturization of semiconductor devices and memory devices. The main problem in the DRAM capacitor is attaining a high capacitance in a small region.

The capacity of a capacitor is proportional to the dielectric constant and the increase of the thin film area in a capacitor. it is also inversely proportional to the increase in the thickness of the film. Therefore, in order to increase the capacity of a miniaturized DRAM device, the thickness of a thin film should be decreased, the structure of a capacitor should be modified so that the effective area of dielectric material is maximized, a high dielectric substance should be used as the dielectric, or the dielectric constant should be increased in a limited DRAM device.

For example, to maximize the effective area of a dielectric thin film in a capacitor within a limited space, a cell having a 3-dimensional structure was built. Thus, in order to increase the effective area of a 4 mega DRAM, a 2-dimensional structure was modified to a 3-dimensional structure, i.e., a capacitor having a stack or trench structure. In 16 mega or 64 mega DRAM devices, the structure becomes more complex, such as a fin cylinder or crown structure having a complex 3-dimensional construction. However, the above method requires a complex structure in a capacitor which, for a DRAM device larger than a 256 mega class, such as 1 giga class, is difficult to manufacture and would result in a higher production cost. Therefore, there is a limit to the application of a 3-dimensional structure to a capacitor.

The capacitance can be increased by decreasing the thickness of dielectric film. Even if a 3-dimensional structure were used to increase the effective area in a capacitor using conventional combined "NO" (or $Si_3N_4/SiO_x$) dielectrics to maintain the minimum capacitance of 25 to 30 fF (femptoFarrads), the dielectric film thickness has to decrease to 40-45 Angstroms ("Å"). However, the decrease in the thickness will cause an increase in the leak current due to tunneling or it will cause the soft error by alpha-particles, which affects the reliability of the device.

The currently available low dielectric constant dielectrics, such as "ONO" (or $SiO_2/SiN_4/SiO_x$) and "NO" (or $Si_3N_4/SiO_x$) must be replaced with a high dielectric constant dielectric. Currently, one method of securing sufficient capacitance of a capacitor in the manufacturing process of the next generation memory devices, such as 256 mega class, is to use a highly dielectric material for the dielectric film in the capacitor. These materials have been studied by many companies and research laboratories.

When a high dielectric constant material is used as a dielectric for a capacitor, the shortcomings, such as manufacturing difficulty, complexity of capacitor structure, low reliability of the device, etc., can be overcome.

Currently, some of the high dielectric constant materials which have been examined are "BST", or (Ba,Sr) $TiO_3$, which is contains barium oxide (BaO), strontium oxide (SrO) and titanium oxide ($TiO_2$), and "PLZT", such as $Pb_{1-x},La_xZr_{1-y}O_3$, or "PZT", such as $Pb(Zr,Ti)O_3$. These dielectric materials are expected to be used in capacitors in next generation DRAM devices.

Characteristically, BST is paraelectric and is suitable for dielectrics in the next generation DRAM devices, and P(L)ZT is a strong dielectric material and has a self-induced polarization property, which is one of the specific properties of a strong dielectric material. P(L)ZT materials are suitable for dielectrics for capacitors for nonvaporizing memory devices. These materials have been studied by the semiconductor industries and related organizations. BST and P(L) ZT thin films can be prepared by the sol-gel process, sputtering, or the chemical vapor deposition process ("CVD").

Thin film formation by the CVD process is a selected deposition process. This process has improved step coverage deposition when compared with other deposition methods. A good step coverage deposition is needed for devices with decreasing cell areas. The process also has a good step coverage during the vapor deposition process, which is suited for the manufacture of the next generation semiconductor devices.

The thin film of BST is formed using organometallic compound precursors. Examples of such compounds are Ba(2,2,6,6-tetramethyl-3,5-heptanedionate)2 which is a barium compound, Sr(2,2,6,6-tetramethyl-3,5-heptanedionate)$_2$ which is a strontium compound, and Ti(isopropoxide)$_4$ or Ti(isopropoxide)$_2$(2,2,6,6-tetramethyl-3,5-heptanedionate)2, which are titanium compounds. These compounds are widely used as precursors for BST thin film vapor deposition and they are especially suited for chemical vapor deposition process in comparison with other compounds of barium, strontium or titanium.

Ba(2,2,6,6-tetramethyl-3,5-heptanedionate)$_2$ and Sr(2,2,6,6-tetramethyl-3,5-heptanedionate)$_2$ have superior properties for chemical vapor deposition processes in BST thin film formation, however, they do nave some shortcomings. These compounds have a low vapor pressure and require heating above 200° C in order to attain the proper vapor pressure needed for thin film vapor deposition. However, in the course of thin film vapor deposition, the high temperature causes a partial thermal decomposition of the precursor, thus, affecting the reproducibility in the semiconductor device manufacturing process. In addition, these precursors are solid and difficult to control their transport from

a precursor reservoir to a thin film vapor deposition reactor. This also contributes to the difficulty of the manufacturing process. Since the low vapor pressure of these precursors results in a low thin film vapor deposition rate, this is inefficient in respect to the economics of the process.

To overcome the problems, barium and strontium having ligands of alkoxide and carboxylate derivatives were used as the BST thin film chemical vapor deposition precursors. These compounds are also solids, and, therefore, they have low vapor pressure and low thermal stability as precursors in BST-CVD processes.

One attempt at a solution was to use existing precursor compounds, Ba(2,2,6,6-tetramethyl-3,5-heptanedionate)$_2$ and Sr(2,2,6,6-tetramethyl-3,5-heptanedionate)$_2$ as a solution in tetrahydrofuran as solvent. These precursor solutions can be transported in a precursor solution container or by using a direct liquid injector or liquid delivery system under a controlled feed rate to deliver to the vaporizer to induce flash vaporization so as to alleviate the effects of thermal instability and provide homogeneous precursor material. The problems were partially solved and the reproducibility in the manufacturing process improved.

The solubility of the above compounds, Ba(2,2,6,6-tetramethyl-3,5-heptanedionate)$_2$ or Sr(2,2,6,6-tetramethyl-3,5-heptanedionate)$_2$, in tetrahydrofuran is low and such solutions were only available as dilute solution precursors but could still be used in the liquid delivery apparatus. The vapor deposition rate of BST thin film in the next generation memory device manufacture is not suitable because the low vapor deposition rate is dependent upon the concentration of the precursor in solution. Often, due to its low solubility, the residual solid compound which did not vaporize remains in the vaporizer and, even if a new batch of solution is added, the residual solid compound may not be redissolved due to its low solubility. For this reason, the compound accumulates in the vaporizer and it will become clogged.

There is thus a need for vapor deposition precursors that provide the necessary thin film and have a sufficiently high vapor pressure such that they form films and a faster rate than known precursors and do not clog vaporizers used in the deposition process.

## Summary of the Invention

It has now been found that certain organometallic compounds solve the problems of known high dielectric precursors, particularly BST precursors, for CVD processes used in semiconductor manufacture.

The present invention provides an organometallic compound of the Formula

$$M(C_{11}H_{19}O_2)_x(OCH(CH_3)_2)_y : L_n \qquad (I)$$

wherein M is a metal selected from Group IIA, Group IIIA, Group IVA, Group IIIB, Group IVB, Group VB or Group VIIIA; L is an organic amine; n is an integer greater than 1; and x and y are integers from 0 to 4, provided that x + y is an integer from 2 to 4.

The present invention also provides a high dielectric thin film deposition precursor composition comprising an organometallic compound described above.

The present invention further provides a process for preparing an organometallic compound of the Formula

$$M(C_{11}H_{19}O_2)_x(OCH(CH_3)_2)_y : L_n \qquad (I)$$

wherein M is a metal selected from Group IIA, Group IIIA, Group IVA, Group IIIB, Group IVB, Group VB or Group VIIIA; L is an organic amine; n is an integer greater than 1; and x and y are integers from 0 to 4, provided that x + y is an integer from 2 to 4; comprising the steps of reacting a metal, having as a ligand tetramentylheptanedionate or a mixture of tetramentylheptanedionate and isopropoxide, with a Lewis base under inert atmosphere.

The present invention further provides a process for forming a high dielectric thin film comprising the steps of vapor depositing a high dielectric thin film on a substrate heated at 350 to 700° C using argon, helium, hydrogen, oxygen or mixtures thereof as the carrier and reaction gas, wherein the thin film precursor is an organometallic compound of Formula I

$$M(C_{11}H_{19}O_2)_x(OCH(CH_3)_2)_y : L_n \qquad (I)$$

wherein

M is a metal selected from Group IIA, Group IIIA, Group IVA, Group IIIB, Group IVB, Group VB or Group VIIIA;

L is an organic amine;

n is an integer greater than 1; and

x and y are integers from 0 to 4, provided that x + y is an integer from 2 to 4.

Brief Description of the Drawings

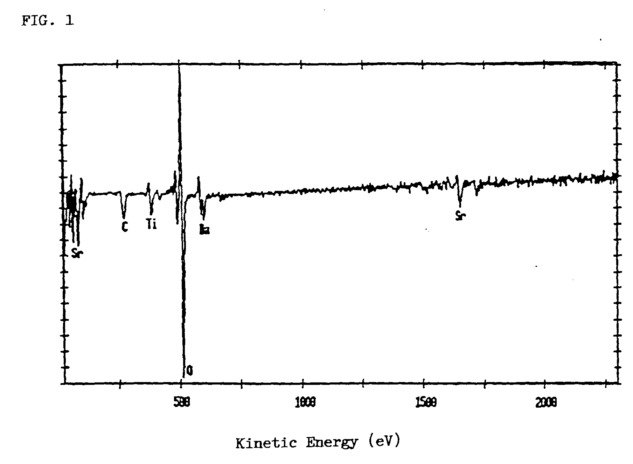

Figure 1 is the Auger electron spectrum of BST thin film obtained using the precursors of the present invention.

Detailed Description of the Invention

This invention provides a wide selection of organometallic compounds for use as vapor deposition precursors in the vapor deposition of BST thin films from barium, strontium or titanium while solving the problems of known vapor deposition precursor solutions.

In order to solve the above-mentioned problems, the present invention provides thin film vapor deposition precursor complex compounds defined by Formula I which are obtained by forming a metal salt ligand and reacting it with a Lewis base. Such Lewis bases are 2,2,6,6-tetramethyl-3,5-heptanedionate (tetramethylheptanedionate, hereinafter) or a mixed ligand consisting of isopropoxide and tetramethylheptanedionate.

$$M(C_{11}H_{19}O_2)_x(OCH(CH_3)_2)_y : L_n \qquad (I)$$

In Formula I, M is a metal selected from Group IIA, Group IIIA, Group IVA, Group IIIB, Group IVB, Group VB and Group VIIIA elements; x and y are integers between zero and 4; provided that x + y is an integer between 2 and 4; L is a Lewis base having a pair of unshared electrons which can be donated to the center of the metal, M; and n is an integer greater than one. Suitable Lewis bases are organic amines, such as one or more selected from isopropylamine, ethylenediamine or heterocyclic amines as defined by Formula II or Formula III, i.e., aziridines, azetidines, pyrrolidines, piperidines, hexamethyleneimines, heptamethyleneimines, morpholines and piperazines.

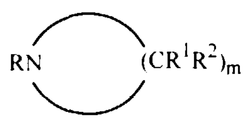

(II)

In Formula II, R is hydrogen or an alkyl group of 1 to 4 carbons, $R^1$ and $R^2$ are each independently hydrogen, or an alkyl group of 1 to 2 carbons, and m is an integer of 2 to 8.

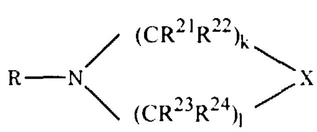

(III)

In Formula III, R is the same as in Formula II, $R^{21}$, $R^{22}$, $R^{23}$ and $R^{24}$ are each independently hydrogen, or an alkyl group of 1 to 2 carbons, X is oxygen or nitrogen containing an alkyl group of 1 to 4 carbons, and k and l are each independently integers of 1 to 3.

Among the compounds represented by Formula II, the preferred compounds are aziridines represented by Formula IV, pyrrolidines represented by Formula V, and piperidines represented by Formula VI. Among the compounds represented by Formula III, the preferred compounds are morpholines represented by Formula III and piperazine represented by Formula VIII.

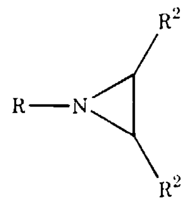

(IV)

In the above Formula IV, R and $R^2$ are as defined in Formula II.

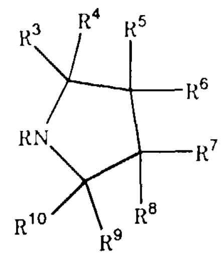

(V)

In the above Formula V, R is as defined in Formula II, and $R^3$ to $R^{10}$ are each independently hydrogen or an alkyl group of 1 to 2 carbons.

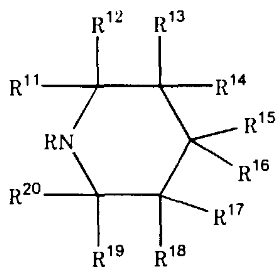

(VI)

In Formula VI, R is as defined Formula II, and $R^{11}$ to $R^{20}$ are each independently hydrogen or an alkyl group of 1 to 2 carbons.

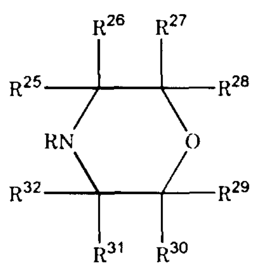

(VII)

In the above Formula VII, R is as defined in Formula II, and $R^{25}$ to $R^{32}$ are each independently hydrogen or an alkyl group of 1 to 2 carbons.

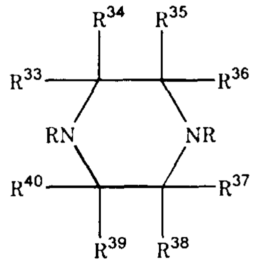

(VIII)

In Formula VIII, R is as defined in Formula II, and $R^{33}$ to $R^{40}$ are each independently hydrogen or an alkyl group of 1 to 2 carbons.

When the Lewis base represented by Formula II is pyrrolidine, the preferred compounds are alkylpyrrolidines represented by Formula IX. In Formula IX, R is an alkyl group of 1 to 4 carbons, and $R^3$, $R^4$, $R^6$, $R^7$, $R^9$ and $R^{10}$ are each independently hydrogen or a methyl group.

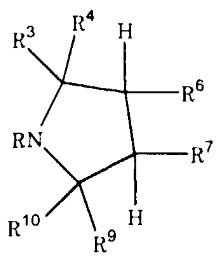

(IX)

Examples of compounds represented by Formula IX are 1,2-dimethylpyrrolidine (Formula X), when R and $R^3$ are $CH_3$, and $R^4$, $R^6$, $R^7$, $R^9$ and $R^{10}$ are hydrogen; 1-methylpyrrolidine (Formula XI), when R is $CH_3$, and $R^3$ to $R^{10}$ are hydrogen; and 1-butylpyrrolidine (Formula XII), when R is $C_4H_9$ and $R^3$ to $R^{10}$ are hydrogen. When the Lewis base is piperidine, represented by Formula VI, the preferred compounds are alkylpiperidines represented by Formula XIII, when R is methyl or ethyl, $R^{11}$, $R^{12}$, $R^{14}$, $R^{16}$, $R^{18}$, $R^{19}$ and $R^{20}$ are methyl. Among the alkylpiperidines of Formula XIII, the preferred compounds are 1,2,2,6,6,-pentamethylpiperidine (Formula XIV), when R, $R^{11}$, $R^{12}$, $R^{19}$ and $R^{20}$ are methyl, and $R^{14}$, $R^{16}$ and $R^{18}$ are hydrogen; and 1-methylpiperidine and 1-ethylpiperidine, represented by Formulae XV and XVI, respectively.

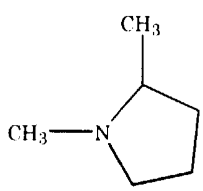

(X)

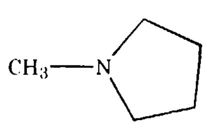

(XI)

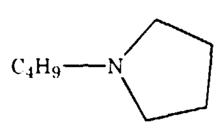

(XII)

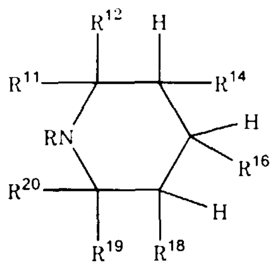

(XIII)

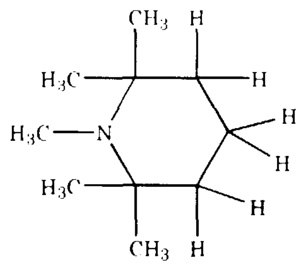

(XIV)

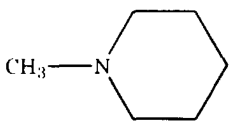

(XV)

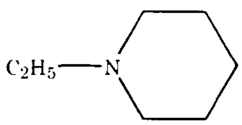

(XVI)

In the compounds of Formula III, when the Lewis base is a morpholine of Formula VII, the preferred compounds are 4-methylmorpholine (Formula XVII) and 4-ethylmorpholine (Formula XVIII).

Among the piperazines of Formula VIII, the preferred compounds are the reaction product of 1,4-dimethylpiperazine (Formula XIX) and diethylaluminum hydride, and the resulting complex of which was used as a chemical vapor deposition precursor in aluminum thin film vapor deposition.

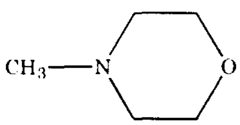

(XVII)

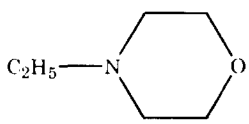

(XVIII)

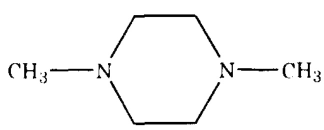

(XIX)

Thus, preferred Lewis bases are aziridines of Formula IV, piperidines of Formula V, and morpholines of Formula VII. It is more preferred that the Lewis base is 1,2-dimethylpyrrolidine, 1-methylpyrrolidine, 1-butylpyrrolidine, 1,2,2,6,6,-pentamethylpiperidine, 1-methylpiperidine, 1-ethylpiperidine, 1-butylpiperidine, 1,2-dimethylpiperidine, 4-methylmorpholine and 4-ethylmorpholine.

Particularly preferred compounds of Formula I are barium tetramethylheptanedionate isopropylamine, barium tetramethylheptanedionate ethylenediamine, strontium tetramethylheptanedionate isopropylamine or strontium tetramethylheptanedionate ethylenediamine.

Also, in the compounds of Formula I, M is a metal selected from Group IIA, such as strontium (Sr) and barium (Ba); Group IVB, such as lead (Pb); Group IIIA such as lanthanum (La); Group IVA, such as titanium (Ti) and zirconium (Zr); and Group VIIIA, such as platinum (Pt). The compounds of Formula I, may be dissolved in a Lewis base, L, as defined in Formula I, to formulate precursor solutions. It is preferred that the metal is calcium, strontium, barium, lead, lanthanum, titanium, zirconium or platinum. Those compounds containing metal were dissolved in isopropylamine, ethylenediamine, pyrrolidine or piperidine and were used for as the precursor solutions in thin film vapor deposition

processes using a liquid delivery system. Especially, the compounds containing strontium (Sr) and barium (Ba) from Group IIA, and lead (Pb) from Group IVB are suitable as precursor solutions in BST thin film and PZT thin film vapor deposition processes.

Other metal compounds can be added to the precursor solutions to form mixed precursor solutions. It is preferred that the precursors of Formula I contain a mixture of two or more metals selected from strontium, barium, lead, lanthanum, titanium, zirconium or platinum.

The precursor solutions of the present invention can be stored for long periods of time and neither precipitation nor decomposition are observed during storage. Moreover, the compounds are highly soluble and it is possible to prepare a highly concentrated precursor solution. Particularly, the high solubility of the barium, strontium and titanium compounds and the properties of the solvents provide easy formulation of mixed solutions of the precursor. Such solutions are ideal precursor solutions for the chemical vapor deposition of the next generation DRAM capacitors with high dielectric constant dielectric thin film vapor deposition.

The precursor solutions of the present invention for BST and PZT thin film vapor deposition for capacitors in next generation semiconductor device manufacture will be discussed where the solutions are formulated with the compounds represented by Formula XX and the Lewis base is as defined in Formula I. The discussion will be focused especially on the solutions of a Lewis base, such as isopropylamine or ethylenediamine.

$$M(C_{11}H_{19}O_2)_2 \qquad (XX)$$

In the above Formula XX, M is a divalent metal such as calcium, barium, strontium or lead.

The expected results of the use of the invention precursor solutions in a chemical vapor deposition of dielectric thin film process using a liquid delivery system are given below.

First, the solubility of the compound of Formula XX in a Lewis base, an amine compound, is high so that it is possible to prepare a highly concentrated solution or a solution having a low concentration over a wide concentration range. Hence, a precursor solution at various concentrations can be prepared for BST and PZT thin film vapor deposition process.

Second, the high solubility of the compounds of Formula XX in an amine enables the redissolution of the unvaporized residual compound in the vaporizer in a liquid delivery system. The revaporization after redissolution by additional precursor solution prevents the accumulation of solid matter and, thus, the clogging of the vaporizer can be alleviated.

Third, since a highly concentrated precursor solution can be used, the vapor deposition rate can be increased.

Fourth, when a conventional solvent, such as tetrahydrofuran, was used in the preparation of a precursor solution by mixing with a solution containing barium, strontium and titanium isopropoxide represented by Formula XX, precipitation may occur due to the interaction of the solutes and their low solubility. When a solvent represented by a Lewis base as defined in Formula I is used, a solvation takes place and the interaction between the solutes is prevented and no precipitation occurs because of the high solubility of the compounds.

The advantage of the above-mentioned mixed solutions is that more than one precursor solution can be transported from a precursor solution reservoir to a vaporizer without using individual tubes attached to each solution reservoir. In other words, the precursor solutions can be mixed in a container and transported through one tube in a dielectric thin film vapor deposition process which simplifies of the vapor deposition process.

The metal compounds of the invention of Formula I, having a ligand, such as tetramethylheptanedionate or a mixture of isopropoxide and tetramethylheptanedionate, and the procedure for the preparation of precursor solutions by dissolving the compounds of the invention in a Lewis base, an amine compound, are described below. Prior to the reaction, the solution must be handled under an inert gas stream, such as nitrogen or argon, in order to prevent contact with air.

The organometallic compounds of Formula can be prepared by reacting a metal, having as a ligand tetramentylheptanedionate or a mixture of tetramentylheptanedionate and isopropoxide with a Lewis base under inert atmosphere to give compounds of Formula I

$$M(C_{11}H_{19}O_2)_x(OCH(CH_3)_2)_y : L_n \qquad (I)$$

wherein M is a metal selected from Group IIA, Group IIIA, Group IVA, Group IIIB, Group IVB, Group VB or Group VIIIB; L is a Lewis base capable of donating an unshared electron pair to the metal and is an organic amine; n is an integer greater than 1; and x and y are integers from 0 to 4, provided that x + y is an integer from 2 to 4. The preferred metals and Lewis base are as described above.

A moisture free, purified metal compound having tetramethylheptanedionate ligand, or isopropoxide and tetramethylheptanedionate mixed ligand of Formula I was dissolved in a Lewis base (L) to prepare a precursor solution according to Equation 1. In this way, a precursor solution can be readily prepared.

Equation 1

$$M(C_{11}H_{19}O_2)_x(OCH(CH_3)_2 + nL \rightarrow M(C_{11}H_{19}O_2)_x(OCH(CH_3)_2)_y : L_n$$

In Equation 1, L, M, x and y are as defined in Formula I, n is a number which represents the number of solvent molecules attached to the solute metal atom as a Lewis base so as to donate an electron pair and then dissociate through solvolysis.

When the organometallic compounds of the present invention are used in a chemical vapor deposition process, the organometallic compounds of Formula I are typically dissolved in a Lewis base, and a high dielectric thin film is vapor deposited on a substrate heated at 350 to 700° C using argon, helium, hydrogen, oxygen or mixtures thereof as the carrier and reaction gas. Typically, the process gas is excited by thermal energy, plasma or by the application of a bias on the substrate. Mixtures of compounds of Formula I may be used in this process. In a vapor deposition process it is preferred that the precursors of Formula I contain a mixture of two or more metals selected from strontium, barium, lead, lanthanum, titanium, zirconium or platinum.

The preparation of the invention precursor solutions will be discussed in detail with examples.

Example 1: Preparation of Barium Tetramethylheptanedionate Isopropylamine Precursor

Three-hundred milliliters ("mL") of dried ethanol was added slowly under a nitrogen stream to a vessel chilled with ice-water containing 41 g (0.3 mole) barium to precipitate a white barium ethoxide suspension. The contents were stirred at room temperature for about 3 hours until the evolution of hydrogen gas ceased.

After the evolution of hydrogen gas ceased, 111 g (0.6 mole) of 2,2,6,6-tetramethyl-3,5-heptanedionate and 100 mL moisture-free hexane were added at room temperature to the barium ethoxide ethanol suspension. The mixture was then completely dissolved and stirred for about 3 hours to obtain barium tetramethylheptanedionate (Ba $(C_{11}H_9O_2)_2$) suspension in ethanol.

After the reaction was completed, the volatile components in the mixture were removed at 90° C under vacuum and 148 g of white solid barium tetramethylheptanedionate were obtained. The dried solid barium tetramethylheptanedionate was sublimed at 230° C under $10^{-2}$ torr vacuum and collected in a condenser chilled with dry ice, to obtain white crystals. Then, the crystals from the first sublimation were sublimed again to obtain 130 g white crystals of barium tetramethylheptanedionate.

Purified, colorless isopropylamine was added to the crystals of barium tetramethylheptanedionate obtained from the sublimation and, while the white crystals were being dissolved, a light yellow solution of barium tetramethylheptanedionate isopropylamine was obtained. The volatile components in the resulting solution were removed at room temperature under vacuum to obtain a light yellow color solid which was analyzed by proton nuclear magnetic resonance analysis for confirmation. The results are listed in Table 1, and confirmed that the resulting compound had Formula XXI, where n is any number.

$$(H_2NCH(CH_3)_2)_nBa(C_{11}H_{19}O_2)_2 \qquad (XXI)$$

The isopropylamine solvent induced changes in the physical properties, melting point and evaporation point, of the barium tetramethylheptanedionate. The reaction path in this Example is illustrated by the following equations.

Equation 2

$$Ba + 2CH_3CH_2OH \rightarrow Ba(OCH_2CH_3)_2 + H_2\uparrow$$

Equation 3

$$Ba(OCH_2CH_3)_2 + 2(CH_3)_3CCOCH_2COC(CH_3)_3 \rightarrow Ba((CH_3)_3CCOCHCOC(CH_3)_3)_2 + 2C_2H_5OH$$

Equation 4

$$Ba((CH_3)_3CCOCH_2COC(CH_3)_3)_2 + nH_2CH(CH_3)_2 \rightarrow (H_2NCH(CH_3)_2)_nBa((CH_3)_3CCOCHCOC(CH_3)_3)_2$$

Example 2: Preparation of Barium Tetramethylheptanedionate Ethylenediamine Precursor

To barium tetramethylheptanedionate prepared according to Example 1, colorless, purified ethylenediamine was added to obtain a yellow barium tetramethylheptanedionate ethylenediamine precursor solution, and the volatile components in the solution were removed under vacuum to obtain a yellow solid which was analyzed by proton nuclear magnetic resonance. It was confirmed that barium tetramethylheptanedionate formed a complex compound with ethylenediamine. The analytical data and the physical properties are listed in Table 1.

Ethylenediamine combined with barium tetramethylheptanedionate and formed a complex compound which changed the physical properties, melting point and evaporation point, but did not change the chemical characteristics.

Example 3: Preparation of Strontium Tetramethylheptanedionate Isopropylamine Precursor

Twenty-six grams ("g") (0.3 mole) of strontium was placed in a container chilled with ice-water and 300 mL of dried ethanol were added to the container under a nitrogen stream, with stirring, to obtain a white strontium ethoxide suspension, and then stirred at room temperature for about 5 hours until the evolution of hydrogen ceased.

When the hydrogen evolution ceased, 111 g (0.6 mole) of 2,2,6,6-tetramethyl-3,5-heptanedionate and 200 mL of dried, purified hexane were added to the strontium ethoxide suspension in ethanol. After the complete dissolution of the mixture, the mixture was further stirred for about 3 hours to obtain a solution mixture containing strontium tetramethylheptanedionate ($Sr(C_{11}H_{19}O_2)_2$).

Upon completion of the reaction, the volatile components in the mixture were removed at 90° C under vacuum and 135 g of solid strontium tetramethylheptanedionate were obtained. The dried solid strontium tetramethylheptanedionate was sublimed at 230° C and under $10^{-2}$ torr and condensed in a condenser chilled with dry ice to obtain 122g of white crystals of strontium tetramethylheptanedionate.

To the strontium tetramethylheptanedionate obtained from the sublimation, colorless, purified isopropylamine was added and, after dissolving the white crystals, a light yellow colored solution of strontium tetramethylheptanedionate isopropylamine solution was obtained. The volatile components in the resulting solution were removed completely at room temperature under vacuum and a light yellow colored solid resulted. The solid was analyzed by proton nuclear magnetic resonance for confirmation. The results are shown in Table 1, and the resulting compound was a complex compound of Formula XXII, where n is any number.

$$(C_{11}H_{19}O_2)_2Sr(H_2NCH(CH_3)_2)_n \qquad \text{(XXII)}$$

Example 4: Preparation of Strontium Tetramethylheptanedionate Ethylenediamine Precursor

The same amount of strontium as in Example 3 was subjected to the procedure of Example 3, with the exception that ethylenediamine was used as a Lewis base to obtain a light greenish strontium tetramethyiheptanedionate ethylenediamine solution. The resulting solution was evaporated under vacuum to obtain a light yellow solid compound which was then analyzed by proton nuclear magnetic resonance to confirm the compound was strontium tetramethylheptanedionate ethylenediamine. The analytical data on the physical properties are reported in Table 1.

Table 1

| Example | Compound | Phase @ 18° C | Color | NMR Analysis ($C_6D_6$, ppm) |
|---|---|---|---|---|
| 1 | $(C_{11}H_{18}O_2)_2Ba(H_2NCH(CH_3)_2)_n$ | Solid | light yellow | δ 5.79 (s)<br>δ 2.84 (m)<br>δ 1.28 (s)<br>δ 1.16 (s)<br>δ 0.87(d) |
| 2 | $(C_{11}H_{18}O_2)_2Ba(H_2N(CH_2)_2NH_2)_n$ | Solid | light yellow | δ 5.80 (s)<br>δ 2.28 (s)<br>δ 1.31 (s)<br>δ 1,13 (s) |
| 3 | $(C_{11}H_{18}O_2)_2Sr(H_2NCH(CH_3)_2)_n$ | Solid | light yellow | 6 5.86 (s)<br>δ 2.87 (m)<br>δ 1.31 (s)<br>δ 1.16 (s)<br>δ 0.91 (d) |
| 4 | $(C_{11}H_{18}O_2)_2Sr(H_2N(CH_2)_2NH_2)_n$ | Solid | light yellow | δ 5.75 (s)<br>δ 2.32 (s)<br>δ 1.30 (s)<br>δ 1.11 (s) |

Example 5: Preparation Of Complex Compound From Barium Tetramethylheptanedionate and Strontium Tetramethylheptanedionate Mixture and Isopropylamine

The procedure of Example 1 was followed using 20 g (0.15 mole) barium and 13 g (0.15 mole) strontium, respectively, to obtain barium tetramethylheptanedionate and strontium tetramethylheptanedionate, and then they were mixed together. Purified, colorless isopropylamine was added to the mixture to dissolve the mixture and to obtain a light green solution. The volatile components in the solution were removed and the resulting solid was analyzed by nuclear magnetic resonance. The results showed that barium tetramethylheptanedionate and strontium tetramethylheptanedionate had formed a complex compound. The results showed that isopropylamine induced changes to the physical properties of the solutes rather than to the chemical properties of the solutes.

Example 6: Preparation of Mixed Isopropylamine Complex Precursor Solution From Barium Tetramethylheptanedionate, Strontium Tetramethylheptanedionate and Isopropoxytitaniurn Tetramethylheptanedionate

The crystals of barium tetramethylheptanedionate (10 g), strontium tetramethylheptanedionate (4.5 g), and isopropoxytitanium tetramethylheptanedionate (10 g) were mixed and then the mixture was dissolved in 200 mL of purified, colorless isopropylamine to obtain a light yellow color solution containing mixed complex compound consisting barium tetramethylheptanedionate, strontium tetramethylheptanedionate, and isopropoxytitanium tetramethylheptanedionate. The resulting solution was allowed to stand for a long time and neither precipitation nor color change was observed.

Test Example

An 8 mL portion of the light yellow solution from Example 6 was heated at 200° C and during the heating the pressure was reduced to 1 x $10^{-2}$ torr to vaporize the solution and to carry out chemical vapor deposition on a 900 Angstrom-thick, titanium nitride coated, silicon substrate heated at 300 to 330° C. The resulting BST thin film from this

vapor deposition process was analyzed by Auger electron spectroscopy ("AES") which showed that the thin film consisted of barium, strontium, titanium and oxygen, which is shown in Figure 1.

As confirmed by the above examples and tests, the precursor compound solutions of the present invention useful for the vapor deposition of a high dielectric material neither decomposed nor precipitated during a long storage period. The superior solubility allows for the preparation of highly concentrated precursor solutions which do not clog direct liquid injectors or liquid delivery systems.

## Claims

**1.** An organometallic compound of the Formula

$$M(C_{11}H_{19}O_2)_x(OCH(CH_3)_2)_y : L_n \qquad (I)$$

wherein

M is a metal selected from Group IIA, Group IIIA, Group IVA, Group IIIB, Group IVB, Group VB or Group VIIIA;

L is an organic amine;

n is an integer greater than 1; and

x and y are integers from 0 to 4, provided that x + y is an integer from 2 to 4.

**2.** The organometallic compound of claim 1 wherein the metal is selected from calcium, strontium, barium, lead, lanthanum, titanium, zirconium or platinum.

**3.** The organometallic compound of claim 1 wherein L is selected from amines of Formulae II or III

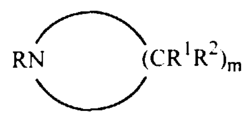

(II)

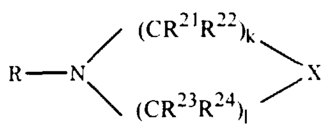

(III)

wherein

R is hydrogen or an alkyl group of 1 to 4 carbons;

$R^1$ and $R^2$ are each independently hydrogen, or an alkyl group of 1 to 2 carbons;

$R^{21}$, $R^{22}$, $R^{23}$ and $R^{24}$ are each independently hydrogen, or an alkyl group of 1 to 2 carbons;

X is oxygen or nitrogen containing an alkyl group of 1 to 4 carbons;

m is an integer of 2 to 8; and

k and l are each independently integers of 1 to 3.

**4.** The organometallic compound of claim 3 wherein L is selected from aziridines, pyrrolidines, piperidines, morpholines or piperazine.

**5.** The organometallic compound of claim 4 wherein L is selected from 1,2-dimethylpyrrolidine, 1-methylpyrrolidine, 1-butylpyrrolidine, 1,2,2,6,6,-pentamethylpiperidine, 1-methylpiperidine, 1-ethylpiperidine, 1-butylpiperidine, 1,2-dimethylpiperidine, 4-methylmorpholine or 4-ethylmorpholine.

**6.** The organometallic compound of claim 1 wherein the compound is selected from barium tetramethylheptanedionate isopropylamine, barium tetramethylheptanedionate ethylenediamine, strontium tetramethylheptanedionate isopropylamine or strontium tetramethylheptanedionate ethylenediamine.

**7.** A high dielectric thin film deposition precursor composition comprising an organometallic compound of claim 1.

**8.** The high dielectric thin film deposition precursor composition of claim 7 further comprising an organic solvent selected from isopropylamine, ethylenediamine, pyrrolidine or piperidine.

**9.** A process for preparing an organometallic compound of the Formula

$$M(C_{11}H_{19}O_2)_x(OCH(CH_3)_2)_y : L_n \qquad (I)$$

wherein

M is a metal selected from Group IIA, Group IIIA, Group IVA, Group IIIB, Group IVB, Group VB or Group VIIIA;

L is an organic amine;

n is an integer greater than 1; and

x and y are integers from 0 to 4, provided that x + y is an integer from 2 to 4; comprising the steps of reacting a metal, having as a ligand tetramentylheptanedionate or a mixture of tetramentylheptanedionate and isopropoxide, with a Lewis base under inert atmosphere.

**10.** A process for forming a high dielectric thin film comprising the steps of vapor depositing a high dielectric thin film on a substrate heated at 350 to 700° C using argon, helium, hydrogen, oxygen or mixtures thereof as the carrier and reaction gas, wherein the thin film precursor is an organometallic compound of Formula I

$$M(C_{11}H_{19}O_2)_x(OCH(CH_3)_2)_y : L_n \qquad (I)$$

wherein

M is a metal selected from Group IIA, Group IIIA, Group IVA, Group IIIB, Group IVB, Group VB or Group VIIIA;

L is organic amine;

n is an integer greater than 1; and

x and y are integers from 0 to 4, provided that x + y is an integer from 2 to 4.

FIG. 1